# EUROPÄISCHE PATENTANMELDUNG

(11) **EP 0 982 761 A1**
(43) Veröffentlichungstag der Anmeldung: **01.03.2000**
(21) Anmeldenummer: 99115069.9
(22) Anmeldetag: 05.08.1999
(51) Int. Cl.: H01L 21/00, H01L 21/324, H01L 21/30

(54) **Verfahren und Vorrichtung für die Wärmebehandlung von Halbleiterplatten**

(30) Priorität: 27.08.1998 DE 19839092
(71) Anmelder: Wacker Siltronic Gesellschaft für Halbleitermaterialien Aktiengesellschaft, 84489 Burghausen (DE)
(72) Erfinder: Buchner, Alfred A., 5233 Pischelsdorf 66 (AT); Teuschler, Thomas, Dr., 269199 Duchess Crest (SG); Sperl, Johann, 84359 Simbach/Inn (DE); Bauer, Theresia, Dr., 84508 Burgkirchen (DE)
(74) Vertreter: Rimböck, Karl-Heinz, Dr.

(57) **Zusammenfassung**

Die Erfindung bezieht sich auf ein Verfahren für die Wärmebehandlung von Halbleiterplatten, vorzugsweise von monokristallinen Reinstsiliciumplatten, mittels einer oberen und einer unteren Heizquelle, insbesondere mehreren oberen und mehreren unteren Lampen oder Lampenbänken, in der Prozeßkammer einer RTP-Anlage, dadurch gekennzeichnet, daß die Wärmebehandlung an zumindest zwei parallel übereinander, beabstandet angeordneten, hinsichtlich der geometrischen Abmessungen und der thermischen Materialeigenschaften identischen Platten erfolgt.

## Beschreibung

Die Erfindung bezieht sich auf ein Verfahren für die Wärmebehandlung von Halbleiterplatten, mittels oberen und unteren Heizquellen in einer Prozeßkammer. Die Erfindung bezieht sich auch auf eine Vorrichtung zur Aufnahme der Halbleiterplatten während der Wärmebehandlung.

Halbleiterplatten werden einer Vielzahl von Behandlungsverfahren, wie beispielsweise Wärmebehandlungsverfahren, unterworfen. Während dieser Wärmebehandlungsverfahren, auch Temper- oder RTP-Verfahren (Rapid Thermal Processing) genannt, werden die Halbleiterplatten für kurze Zeit, bevorzugt für einige Sekunden auf Temperaturen von vorzugsweise zwischen 500 und 1200 °C erwärmt. Derartige Wärmebehandlungen dienen beispielsweise der Ausheilung von Kristalldefekten, der Herstellung dünner Oberflächenbeschichtungen oder zu Reinigungszwecken und erfolgen in RTP-Reaktoren, die über ansteuerbare Wärmequellen, wie beispielsweise Lampen, verfügen. Das Erwärmen des Materials erfolgt dabei durch Bestrahlung mit sichtbarem oder infrarotem Licht in Prozeßkammern mit relativ kleinem Volumen. RTP-Reaktoren ermöglichen damit eine schlagartige Änderung der Temperatur des Materials in der Prozeßkammer.

Eine optimale Prozessierung (schnelles Aufheizen, Halteschritt, schnelles Abkühlen) gelingt in kompakten Einzelplattenreaktoren, die so gestaltet sind, daß nur das zu behandelnde Material, nicht aber großflächige Reaktorwände oder ein großes Gasvolumen mitgeheizt werden.

Aber nicht nur ein schnelles Aufheizen und ein schnelles Abkühlen, sondern auch eine gleichmäßige Temperaturverteilung über die Halbleiterplatten und eine identische Wärmebehandlung einer Charge von Halbleiterplatten ist wesentlich für eine erfolgreiche Prozessierung.

Unterschiedliche Konstruktionen der RTP-Reaktoren, wie beispielsweise der Aufnahmevorrichtungen für die Halbleiterplatten, oder der Wärmequellen verursachen verschiedene Temperatur-Inhomogenitäten, insbesondere am Rand des zu behandelnden Materials.

Daraufhin wurde bekannt, daß beispielsweise ein ringförmiges Element, dessen Innendurchmesser größer ist als der Durchmesser des plattenförmigen Materials, einen erhöhten Wärmeverlust am Rand der Platte während der Wärmebehandlung auszugleichen vermag. Zu strukturinduzierten Temperatur-Inhomogenitäten kommt es insbesondere dann, wenn Platten einer Wärmebehandlung unterliegen, die unterschiedliche Materialien oder Beschichtungen in einer geometrisch oder chemisch strukturierten Form aufweisen. In der DE 42 23 133 C2 wird die Reduktion der strukturbedingten thermischen Inhomogenitäten durch die unabhängige Kontrolle der Lampenleistung sowie die unabhängige Kontrolle der oberen und unteren Lampenbänke bei Anlagen, in welchen die Platten gleichzeitig von oben und von unten beheizt werden können, beschrieben.

Die DE 44 37 361 C2 dagegen beschreibt ein Verfahren und eine Vorrichtung zur schnellen thermischen Behandlung empfindlicher Bauelemente der Halbleiterindustrie, wie beispielsweise integrierte Schaltkreise auf Halbleiterscheiben, mit welchem und mit welcher aktive und passive strukturbedingte thermische Inhomogenitäten verringert werden können. Erfindungsgemäß werden dabei durch die Verwendung einer Licht-Transformator-Platte und eines Pyrometers speziell rückseitenbeschichtete, mit empfindlichen Bauelementen bestückte Halbleiterscheiben erfolgreich wärmebehandelt. Nachteilig an diesem Verfahren ist, daß immer nur eine Produktionsscheibe behandelt werden kann und daß zunächst die Licht-Transformator-Platte aufgeheizt werden muß. Die von der Technologie vorgeschriebene Aufheizgeschwindigkeit und die Kapazitätsanforderungen für eine wirtschaftliche Fertigung können damit aber nicht erfüllt werden. Darüber hinaus muß jedesmal nach der Behandlung einer Produktionsscheibe für die nachfolgende Behandlung einer Produktionsscheibe mit unterschiedlicher Beschichtung, thermischer Materialeigenschaft oder geometrischer Abmessung die Licht-Transformator-Platte ausgetauscht werden. Jeder Austausch der Licht-Transformator-Platte wirkt sich aber ebenfalls nachteilig auf die Produktionsscheiben aus, da in die Prozeßkammer Kontaminationen, wie beispielsweise Partikel eingetragen werden.

In den oben genannten Druckschriften werden unterschiedliche Lösungsvorschläge für eine homogene Wärmebehandlung von Halbleiterscheiben sowie von empfindlichen Bauelementen der Halbleiterindustrie gemacht, wobei diese Art der Wärmebehandlung auf die Behandlung von jeweils nur einer Produktionsscheibe beschränkt ist. Die homogene Wärmebehandlung von zumindest zwei Halbleiterplatten, vorzugsweise monokristallinen Reinstsiliciumplatten mit identischen geometrischen Abmessungen, die keinen strukturinduzierten, thermischen Inhomogenitäten unterliegen und Wärmeverluste wechselwirkend auszugleichen vermögen, ist dagegen in keiner Druckschrift offenbart.

Die Aufgabe der Erfindung bestand daher darin, ein Verfahren und eine Vorrichtung anzugeben, mit welchem und mit welcher zumindest zwei Halbleiterplatten gleichzeitig einer homogenen Wärmebehandlung unterzogen werden, und nachfolgend als Produktionsplatten Verwendung finden.

Gelöst wird die Aufgabe durch ein Verfahren für die Wärmebehandlung von Halbleiterplatten mittels oberen und unteren Heizquellen, insbesondere mehreren oberen und mehreren unteren Lampen oder Lampenbänken, in einer Prozeßkammer, dadurch gekennzeichnet, daß die Wärmebehandlung an zumindest zwei parallel übereinander, beabstandet angeordneten, hinsichtlich der geometrischen Abmessungen und der thermischen Materialeigenschaften identischen Platten erfolgt.

Gelöst wird die Aufgabe auch durch eine Aufnahmevorrichtung für die Wärmebehandlung von Halbleiterplatten in einer Prozeßkammer, gekennzeichnet durch einen in der Prozeßkammer befestigten Trägerrahmen (1) mit nach innen reichenden Auslegern (2) mit Auflagen (3), die eine parallele Beabstandung ermöglichen.

Werden zwei Platten parallel übereinander, beabstandet angeordnet, so sind die sich gegenüber liegenden Plattenoberflächen des Stapels von der Wärmequelle durch die jeweils andere Platte abgeschirmt. Daraus resultiert eine inhomogene Temperaturverteilung der einzelnen Plattenoberflächen, wodurch eine identische Wärmebehandlung dieser Charge von Platten nicht zu erwarten ist.

Überraschenderweise zeigte sich aber, daß zwei Halbleiterplatten, vorzugsweise monokristalline Reinstsiliciumplatten, homogen wärmebehandelt werden können, wenn diese hinsichtlich der geometrischen Abmessungen und der thermischen Materialeigenschaften identisch sind und parallel übereinander, beabstandet angeordnet in der erfindungsgemäßen Aufnahmevorrichtung in einer Prozeßkammer wärmebehandelt werden.

Das erfindungsgemäße Verfahren basiert auf der Ausnutzung eines Energieübergangs zwischen den Platten. Die Plattenoberflächen, die den Lampen zugewandt sind, werden durch die Aufnahme von Strahlungsenergie aus den oberen oder unteren Lampen erwärmt, nachfolgend als Primär-Energiequelle bezeichnet. Die der jeweils anderen Platte zugewandten Oberflächen werden durch Reflexion und Emission von Strahlungsenergie der jeweils anderen Halbleiterplatte erwärmt, nachfolgend als Sekundär-Energiequelle bezeichnet. Die Strahlungsenergieabgabe ist dabei identisch, da es sich hinsichtlich der thermischen Materialeigenschaften und der geometrischen Abmessungen um identische Platten handelt. Die Wärmebehandlung erfolgt durch eine Primär- und eine Sekundär-Energiequelle.

Als besonders vorteilhaft an dem erfindungsgemäßen Verfahren erweist sich eine Kapazitätssteigerung gegenüber dem Stand der Technik, da durch die homogene Wärmebehandlung beide Platten als Produktionsplatten Verwendung finden. Da ein Austausch von Licht-Transformator-Platten entfällt und die erfindungsgemäße Aufnahmevorrichtung in der Prozeßkammer befestigt ist, werden keine Kontaminationen, wie beispielsweise Partikel, in die Prozeßkammer eingetragen.

Gemäß einer bevorzugten Ausführungsform werden zunächst die Halbleiterplatten, vorzugsweise monokristalline Reinstsiliciumplatten, in die erfindungsgemäße Aufnahmevorrichtung, die in der Prozeßkammer eines RTP-Reaktors mit ansteuerbaren Lampenbänken oder ansteuerbaren Lampen befestigt ist, übergeführt. Die Aufnahmevorrichtung kann dabei mit zumindest zwei monokristallinen Reinstsiliciumplatten gleichzeitig oder nacheinander beladen werden. Dann werden die Platten durch Strahlungsenergie, vorzugsweise mit einer Aufheizrate von 50 bis 500°C/s auf Temperaturen von vorzugsweise zwischen 500 und 1200°C erwärmt. Anschließend wird die Temperatur durch fortgesetzte Einstrahlung von Energie vorzugsweise 1 bis 300 s gehalten. Schließlich erfolgt eine Abkühlphase vorzugsweise mit -10 bis -100 °C/s.

Da vor der Wärmebehandlung der Platten zunächst eine Optimierung, beispielsweise der Lampenleistung, durch Versuchsreihen erfolgen muß, werden bevorzugt nur Platten gleicher Gattung, vorzugsweise monokristalline Reinstsiliciumplatten, mit identischen thermischen Materialeigenschaften und geometrischen Abmessungen, wärmebehandelt.

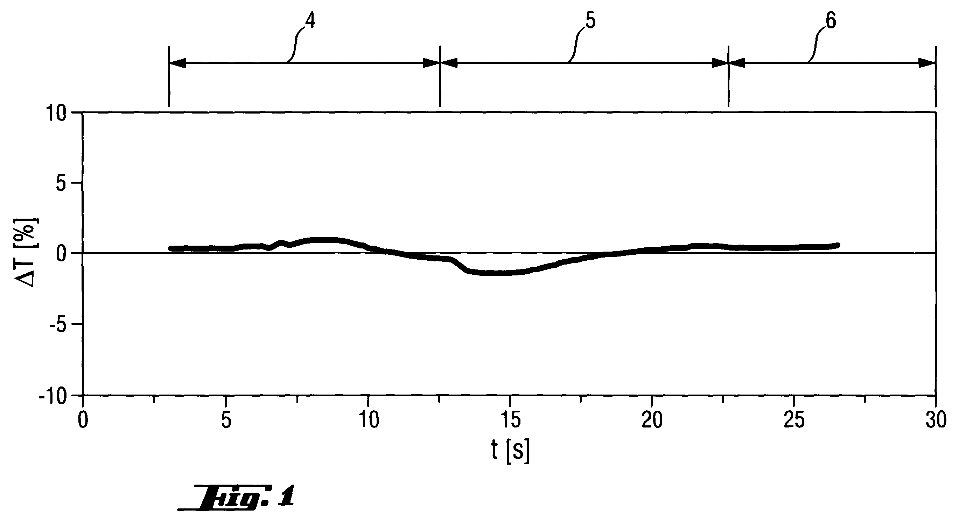

Die vom Fachmann geforderte homogene Temperaturverteilung über die Halbleiterplatten sowie die identische Wärmebehandlung einer Charge von Halbleiterplatten gleicher Gattung wird mit dem erfindungsgemäßen Verfahren erreicht. Fig. 1 zeigt die Leistungsfähigkeit des Verfahrens. Auf zwei parallel übereinander, beabstandet, bevorzugt zwischen 1 und 30 mm, besonders bevorzugt zwischen 10 und 20 mm, angeordneten monokristallinen Reinstsiliciumplatten wurden Thermoelemente angebracht. Anschließend wurden die Platten nach dem erfindungsgemäßen Verfahren wärmebehandelt. Die relative Differenz Δ T in % der von den Thermoelementen gemessenen Temperatur ist in Fig. 1 auf der Ordinate aufgetragen; die Abszisse stellt die Zeitachse t in s dar. Das erfindungsgemäße Verfahren ermöglicht während der Aufheiz-, (4) Halte- (5) und Abkühlphase (6) eine nahezu identische Wärmebehandlung dieser Charge von Platten.

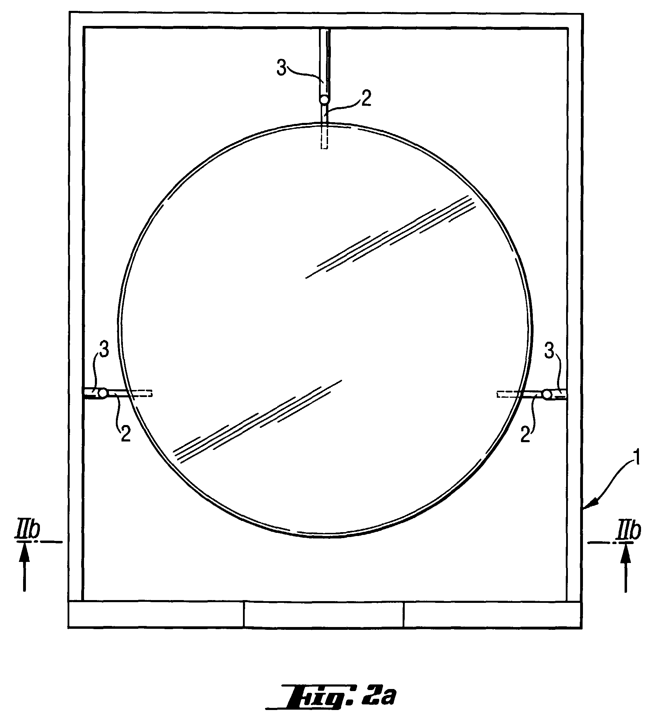

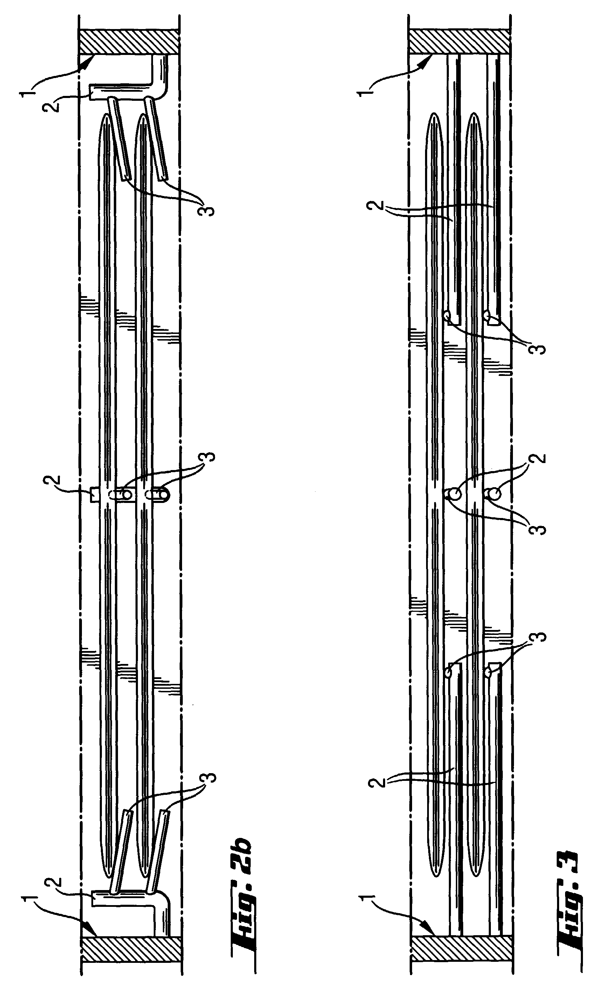

Die erfindungsgemäße Aufnahmevorrichtung zur Durchführung des Verfahrens ist aus einem die Platten nichtkontaminierenden, hitzebeständigem Material, wie beispielsweise Quarzglas, Aluminiumoxid, Siliciumcarbid oder Silicium gefertigt. Eine bevorzugte Ausführungsform der Aufnahmevorrichtung ist in Fig. 2a und 2b dargestellt, wobei die erfindungsgemäße Vorrichtung nicht auf die Form und Größe des Trägerrahmens und der Ausleger und auf die Anzahl der Ausleger und der Aufleger beschränkt ist. Eine weitere bevorzugte Ausführungsform der Aufnahmeform ist in Fig. 3 dargestellt.

Die bevorzugten Ausführungsformen setzen sich aus einem Trägerrahmen (1) und drei nach innen reichenden Auslegern (2) zusammen. An den Auslegern (2) sind Auflagen (3) für die Aufnahme von Halbleiterplatten angebracht. Die Auflagen sind so ausgeführt, daß sie eine parallele Beabstandung der Halbleiterplatten ermöglichen. Die bevorzugte parallele Beabstandung beträgt zwischen 1 und 30 mm, die besonders bevorzugte parallele Beabstandung zwischen 10 und 20 mm. Die Aufnahmevorrichtung, Fig. 3, ermöglicht die Aufnahme von Platten mit unterschiedlichen Durchmessern.

Die Aufnahmevorrichtung ist bevorzugt fest in der Prozeßkammer installiert, um von außen eingetragene Kontaminationen zu verhindern.

## Patentansprüche

1. Verfahren für die Wärmebehandlung von Halbleiterplatten mittels oberen und unteren Heizquellen in einer Prozeßkammer, dadurch gekennzeichnet, daß die Wärmebehandlung an zumindest zwei parallel übereinander, beabstandet angeordneten, hinsichtlich der geometrischen Abmessungen und der thermischen Materialeigenschaften identischen Platten erfolgt.

2. Verfahren nach Anspruch 1, dadurch gekennzeichnet, daß die Platten zwischen 1 und 30 mm beabstandet sind.

3. Verfahren nach Anspruch 1 oder 2, dadurch gekennzeichnet, daß die Wärmebehandlung durch eine Primär- und eine Sekundär-Energiequelle erfolgt.

4. Aufnahmevorrichtung für die Wärmebehandlung von Halbleiterplatten in einer Prozeßkammer, gekennzeichnet durch einen in der Prozeßkammer befestigten Trägerrahmen (1) mit nach innen reichenden Auslegern (2) mit Auflagen (3), die eine parallele Beabstandung ermöglichen.

5. Aufnahmevorrichtung nach Anspruch 4, dadurch gekennzeichnet, daß die Vorrichtung aus einem hitzebeständigen, die Halbleiterplatten nichtkontaminierenden Material besteht.
